# EUROPEAN PATENT APPLICATION

(11) **EP 4 742 465 A2**
(43) Date of publication of application: **13.05.2026**
(21) Application number: 26157026.1
(22) Date of filing: 06.02.2026
(51) Int. Cl.: H01S 3/0941, H01S 3/10, H01S 5/11, H01S 3/08, H01S 3/06

(54) **ARRANGEMENT FOR SOLID-STATE LASER**

(71) Applicant: ASML Netherlands B.V., 5500 AH Veldhoven (NL)
(72) Inventor: REININK, Johan, 5500 AH Veldhoven (NL); O'DWYER, David, 5500 AH Veldhoven (NL)
(74) Representative: ASML Netherlands B.V.

(57) **Abstract**

An arrangement for pumping a gain medium of a solid-state laser to produce laser radiation during production periods separated by dormant periods. The arrangement comprises at least one radiation source and a source driver. The at least one radiation source is configured to provide production radiation of a production wavelength and compensation radiation of a compensation wavelength different from the production wavelength. The source driver is configured to drive the at least one radiation source to provide the production radiation at least during the production periods, wherein the source driver is further configured to drive the at least one radiation source to provide the compensation radiation so as to increase temperature uniformity of the gain medium.

## Description

### FIELD

The present invention relates to an arrangement, a solid-state laser, a DUV radiation source, and a method for producing laser radiation in a gain medium of a solid-state laser.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features, which are patterned on the substrate. Typical wavelengths currently in use are 365 nm, 248 nm, 193 nm, and 13.5 nm.

A deep ultra-violet (DUV) radiation source, typically an excimer gas-based source such as a KrF (248 nm) laser or an ArF (193 nm) laser, may be used to provide the radiation with the required wavelength for the patterning process. Such excimer lasers are expensive to manufacture and can be inefficient.

It is desirable to facilitate the generation of laser radiation at a reduced cost. It is desirable to facilitate more efficient generation of laser radiation, and more particularly DUV radiation. Solid-state lasers are emerging radiation sources providing radiation with suitable wavelengths for lithography applications. Instead of a gaseous medium, the lasing medium of a solid-state laser is a crystal. Solid-state lasers provide reliability, a high quantum efficiency and are relatively simple and easy to maintain.

The crystal (or solid-state medium) of the solid-state laser is pumped by a radiation beam (or pump beam). A portion of the energy of the radiation beam, which is absorbed by the crystal, provides a thermal load to the crystal. Hereby, the temperature of the crystal changes, i.e., the temperature of the crystal increases. As a result of the temperature change, the refractive index of the crystal changes. Typically, the radiation beam generates a temperature distribution in the crystal, and hereby a refractive index distribution. The effect that a refractive index distribution takes on a radiation beam is called thermal lensing. This thermally induced lensing effect alters the properties of the optical path in the crystal for the optical radiation beam passing through the crystal. It is desirable to improve on aspects of thermal lensing in solid-state laser crystals, which obviates or mitigates one or more of the problems of the prior art, whether identified herein or elsewhere.

### SUMMARY

According to a first aspect of the present invention, there is provided an arrangement for pumping a gain medium of a solid-state laser to produce laser radiation during production periods separated by dormant periods. The pump arrangement comprises at least one radiation source that is configured to provide production radiation of a production wavelength and compensation radiation of a compensation wavelength different from the production wavelength to the gain medium, and a source driver configured to drive the at least one radiation source to provide the production radiation at least during the production periods, wherein the source driver is further configured to drive the at least one radiation source to provide the compensation radiation so as to increase temperature uniformity of the gain medium during the usage of the solid-state laser.

According to a second aspect of the present invention, there is provided a method for pumping a gain medium of a solid-state laser to produce laser radiation during production periods separated by dormant periods. The method comprises driving at least one radiation source to provide a production radiation of a production wavelength to the gain medium at least during the production periods, producing laser radiation by the provision of the production radiation, and driving the at least one radiation source to provide a compensation radiation of a compensation wavelength different from the production wavelength so as to increase temperature uniformity of the gain medium during usage of the solid-state laser.

### BRIEF DESCRIPTION OF THE DRAWINGS

Embodiments of the invention will now be described, by way of example only, with reference to the accompanying schematic drawings, in which:
Figure 1 schematically depicts two cross-sectional views of a gain medium being pumped by a radiation beam;
Figure 2 schematically depicts a solid-state laser arrangement;
Figure 3 schematically depicts switching pump radiation for a solid-state laser;
Figure 4 schematically depicts a cavity of a solid-state laser in a cold-state;
Figure 5 schematically depicts the cavity of Figure 4 being in a thermalized state;
Figure 6 schematically depicts cross-sectional view of a pattern of production radiation and compensation radiation;
Figure 7 schematically depicts temperature across the gain medium irradiated according to Figure 6, for example;
Figure 8 schematically depicts a temperature distribution across the gain medium; and
Figure 9 schematically depicts an alternative cavity of a solid-state laser.

Relative dimensions of components in drawings may be exaggerated for clarity. Within the following description of drawings the same or like reference numbers refer to the same or like components or entities, and only the differences with respect to the individual embodiments are described.

### DETAILED DESCRIPTION

In the present document, the terms "radiation" and "beam" are used to encompass all types of electromagnetic radiation, including ultraviolet radiation, visible radiation and near infra-red radiation.

To clarify the invention, a Cartesian coordinate system is used. The Cartesian coordinate system has three axes, i.e., an x-axis, a y-axis and a z-axis. Each of the three axes is orthogonal to the other two axes. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only.

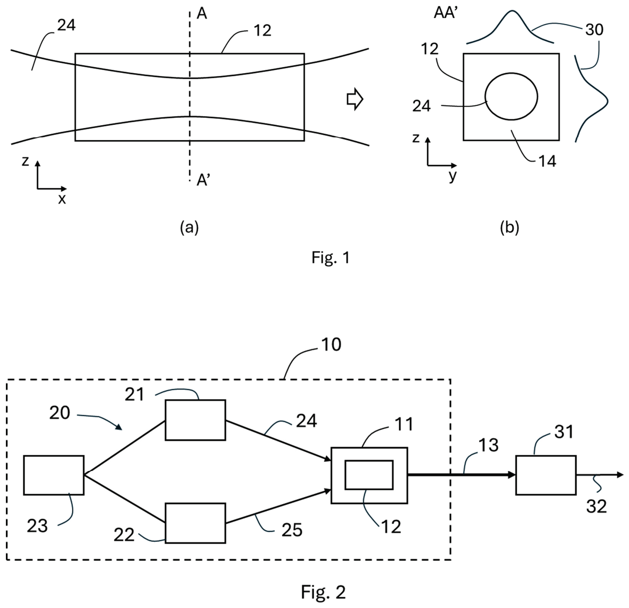

Figure 1 schematically depicts two cross-sectional views (a) and (b) of a crystal 12, for example a gain medium of a solid-state laser, that is being pumped by a beam of radiation 24. The radiation beam 24 propagates through the crystal, as illustrated by the illustration, along the x-direction. Typically, the radiation beam 24 is focused such that a waist of the radiation beam 24 is within the gain medium 12. A portion of the radiation beam 24 is absorbed by the crystal 12. The absorbance of radiation passing through a material is commonly described by Beer-Lambert law. The absorbance of a portion of the radiation causes a (local) change in temperature of the material. In current situation, the radiation beam 24 causes an unwanted transverse thermal gradient (often a longitudinal gradient as well) within the crystal 12, with the thermal gradient leading to thermal lensing. As is illustrated by the cross-section along line AA', Figure 1(b), the radiation beam 24 having a circular cross-section propagates through an active region 14 of the gain medium 12, introducing a radial thermal gradient 30, as illustrated by the profiles along the sides, in the gain medium 12 and causing a variation of the refractive index across the gain medium 12. The variation of the refractive index is governed by the thermal load (illustrated as having a radial thermal gradient 30) and may have a similar spatial distribution, e.g., a radial gradient, as the thermal distribution.

The thermally induced change of the refractive index has the effect that radiation propagating through the crystal, or gain medium 12, experiences an interaction with the crystal that is governed by the local temperature. That is, when the temperature in the crystal changes, for example spatially or temporally, the refractive index of the crystal changes. In turn, the thermally induced refractive index change alters the propagation of the radiation beam through the crystal 12. This may result in a focus displacement or a directional shift of the radiation beam. Hence, the properties of the radiation beam that passed though the crystal 12 (gain medium) is governed by a thermal state of the crystal 12.

Figure 2 schematically depicts a solid-state laser 10. The solid-state laser 10 is configured to produce laser radiation 13. In an embodiment, a DUV radiation source comprises the solid-state laser 10. For example, in an embodiment the DUV radiation source comprises the solid-state laser 10 and a wavelength converter 31 being a non-linear medium, e.g., a non-linear crystal. The wavelength converter 31 may be configured to convert the laser radiation 13 from the solid-state laser 10 into DUV radiation 32. For example, the wavelength converter 31 may be configured to convert the laser radiation 13 into ultraviolet laser radiation 32 having a wavelength of 365 nm, 248 nm or 193 nm.

In an embodiment, the solid-state laser 10 is configured to generate laser radiation 13 having a wavelength in the range of from about 720 nm to about 800 nm, for example. However, in alternative embodiments the solid-state laser 10 is configured to generate laser radiation outside of 720 nm to 800 nm. The gain medium 12 of the solid-state laser 10 may be selected dependent on the desired wavelength of the laser radiation 13.

Merely as one example, in an embodiment the solid-state laser 10 is configured to output radiation 13 at a wavelength of 740 nm to 750 nm, for example 744 nm. The wavelength converter is configured to convert the 740 nm to 750 nm (for example 744 nm) radiation into 245 nm to 250 nm (for example 248 nm) radiation, or radiation within the range of from about 247 nm to about 250 nm. By a so-called third harmonic generation process within one or more non-linear materials 31, radiation with a wavelength of 744 nm is converted into radiation with a wavelength of 248 nm. The third harmonic radiation may be generated, for example, in two steps. In a first step, the 740 nm to 750 nm (for example 744 nm) radiation is partially converted to a second harmonic radiation, for example by pumping a frequency doubling crystal with the fundamental beam (in this example radiation of 744 nm). In the second step, the fundamental beam and second harmonic beam are overlapped in a sum-frequency crystal, where they are partially converted to the third harmonic radiation. The fundamental pump beam may either be a partially depleted fundamental beam from which the second harmonic was generated in the first step, or be split off directly from the laser output and rerouted to bypass the first step.

As another example, in an embodiment the solid-state laser 10 is configured to generate laser radiation 13 at a wavelength of 772 nm. The wavelength converter 31 may convert the 772 nm radiation into 193 nm radiation, or radiation within the range of from about 192 nm to about 195 nm, as a fourth harmonic radiation. That is, by means of a fourth harmonic process within one or more non-linear crystals 31 radiation having a wavelength of 772 nm is converted to radiation with a wavelength of 193 nm. Of course, other radiation wavelengths can be achieved by selecting the gain medium and the harmonic of the produced laser radiation. Of course the wavelength converter 31 may output radiation of a different wavelength, for example in the range of from about 360 nm to about 370 nm. In an embodiment, the wavelength converter may output radiation with a wavelength of 365 nm.

As shown in Figure 2, in an embodiment the solid-state laser 10 comprises a pump arrangement 20. The pump arrangement 20 is configured for pumping the gain medium 12 of the solid-state laser 10. In an embodiment, the pump arrangement 20 is combined with an optical cavity 11 to form the solid-state laser 10. Alternatively, the pump arrangement 20 may be provided as a separate component from the cavity 11.

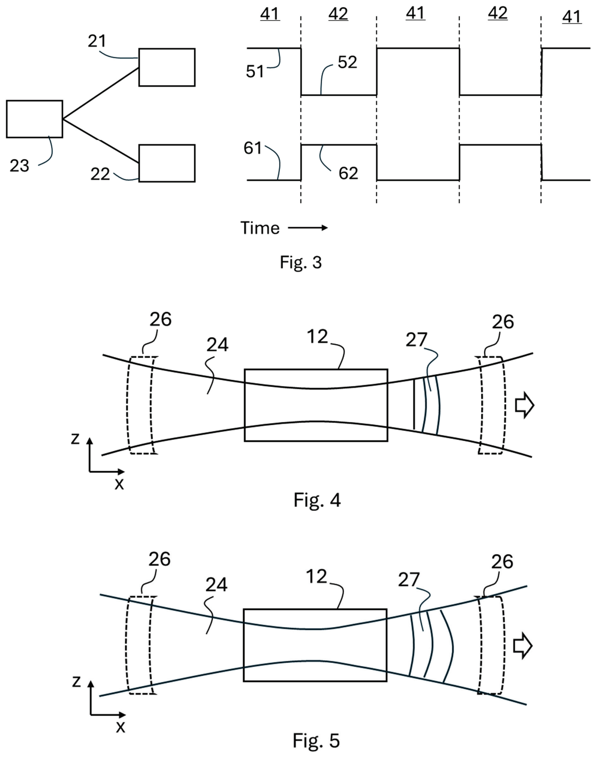

In an embodiment, the solid-state laser 10 is configured to produce laser radiation 13 during production periods 41 (see Figure 3). The production periods 41 may be separated by dormant periods 42. The production periods 41 correspond to periods of time in which the laser radiation 13 (or a radiation such as DUV radiation 32 obtained from the laser radiation 13) is required. The dormant periods 42 correspond to periods of time in which the laser radiation 13 (or radiation converted from the laser radiation 13) is not required. In an embodiment, the solid-state laser 10 is configured to produce the laser radiation 13 only during the production periods 41. That is, the solid-state laser 10 does not produce the laser radiation 13 during the dormant periods 42. In an alternative embodiment, the solid-state laser 10 is configured to produce some laser radiation 13 during both the production periods 41 and the dormant periods 42. During the dormant periods 42, the laser radiation 13 produced by the solid-state laser 10 (or a radiation converted from the laser radiation 13) is diverted or blocked, for example, downstream of the solid-state laser 10. Alternatively, the lasing may be inhibited during the dormant periods 42, for example by modification of the cavity 11. For example, a reflector (e.g., an optical mirror) of the cavity 11 may be moved so as to inhibit the lasing.

As shown in Figure 2, in an embodiment, the pump arrangement 20 comprises at least one radiation source 21, 22. In an embodiment, the pump arrangement 20 comprises a plurality of radiation sources 21, 22. The at least one radiation source 21, 22 is configured to provide production radiation 24 and compensation radiation 25. The production radiation 24 is radiation that has a production wavelength, for example, a wavelength in the range of from about 720 nm to about 800 nm. The compensation radiation 25 is radiation that has a compensation wavelength. The compensation wavelength is different from the production wavelength. That is, the at least one radiation source 21, 22 is configured to provide at least two different wavelengths of radiation.

In the arrangement shown in Figure 2, the pump arrangement 20 comprises two radiation sources 21, 22. A production radiation source 21 is configured to provide the production radiation 24. A compensation radiation source 22 is configured to provide the compensation radiation 25. It is not essential for the pump arrangement 20 to comprise a plurality of radiation sources. In an alternative embodiment the pump arrangement 20 comprises a single radiation source capable of providing at least two different wavelengths of radiation. For example, the radiation source 21, 22 may be switchable between two different modes corresponding to the different wavelengths of radiation.

It is not essential for the solid-state laser 10 to be part of a DUV radiation source. In an alternative embodiment the solid-state laser 10 may be used for a different purpose. For example, the solid-state laser 10 may be used to output the laser radiation 13 that is not required to be converted to a different wavelength before it is used.

As shown in Figure 2, in an embodiment, the pump arrangement 20 comprises a source driver 23. The source driver 23 is configured to drive the at least one radiation source 21, 22. In an embodiment, the source driver 23 is configured to send driving signals to the at least one radiation source 21, 22. For example, as shown in Figure 2, in an embodiment the source driver 23 is configured to output production control signals to the production radiation source 21 and compensation control signals to the compensation radiation source 22.

In an embodiment, a controller is configured to control the source driver 23. Alternatively, the source driver 23 may be part of such a controller. In an embodiment, the controller is configured to control one or more components of a lithographic apparatus, e.g., a lithographic exposure apparatus. In an embodiment, the controller is configured to control the DUV radiation source of a lithographic apparatus.

In an embodiment, the source driver 23 is configured to drive the at least one radiation source 21, 22 to provide the production radiation 24 at least during the production periods 41. By providing the production radiation 24 at least during the production periods 41, the gain medium 12 is pumped by the production radiation 24 at least during the production periods 41. The production radiation 24 causes the gain medium 12, which may be arranged in the cavity 11, to generate the laser radiation 13 produced by the solid-state laser 10. Thus, the solid-state laser 10 is configured to generate the laser radiation 13 during the production periods 41.

As explained in a previous paragraph, with reference to Figure 1, the gain medium 12 (or crystal) may experience a thermal load by interaction with radiation. For example, during the production periods 41, a portion of the production radiation 24 is absorbed by the gain medium 12, resulting in a (local) change in temperature of the gain medium 12. In turn, the production radiation 24 experiences (self-induced) thermal lensing while propagating through the gain medium 12.

In an embodiment, the source driver 23 is configured to drive the at least one radiation source 21, 22 to provide the compensation radiation 25 so as to increase a temperature uniformity of the gain medium 12. An increase in uniformity may correspond to a reduction in variation, spatially as well as temporarily. In an embodiment, the source driver 23 is configured to drive the at least one radiation source 21, 22 to provide the compensation radiation 25 so as to reduce temperature variation of the gain medium 12. An embodiment of the invention is expected to improve thermal stability of the solid-state laser 10. An embodiment of the invention is expected to stabilise the gain medium 12 thermally. An embodiment of the invention is expected to increase uniformity of the refractive index of the gain medium 12. An embodiment of the invention is expected to reduce variability of thermal lensing of the gain medium 12.

During use of the solid-state laser 10, the gain medium 12 is susceptible to thermal lensing. The refractive index of the gain medium 12 depends on the temperature of the gain medium 12. During use of the solid-state laser 10, the gain medium 12 can heat up. For example, as the gain medium 12 is pumped, the quantum defect of the gain medium 12 can result in energy losses in the form of heat.

The transportation of the heat away from the gain medium 12 during dormant periods 42 results in a variation in temperature. Such a variation in temperature is undesirable because of the associated variation in refractive index. By providing the compensation radiation 25, the temperature uniformity of the gain medium 12 can be increased. In an embodiment, the temperature uniformity of the gain medium 12 is increased compared to a situation, wherein the compensation radiation 25 is not provided to the gain medium 12.

Figure 3 schematically depicts switching of the pump radiation provided to the gain medium 12. Figure 3 schematically depicts the production radiation source 21 and the compensation radiation source 22. Embodiments are described primarily in a context of the pump arrangement 20 comprising two radiation sources 21, 22. However, the pump arrangement 20 may alternatively comprise a single radiation source or more than two radiation sources, for example. Figure 3 diagrammatically shows the production periods 41 separated by the dormant periods 42, for example in a cyclic order. In Figure 3, time is represented along the horizontal direction.

In an embodiment, the source driver 23 is configured to drive the at least one radiation source 21, 22 to provide the compensation radiation 25 during the dormant periods 42. The provision of the compensation radiation 25 by the compensation radiation source 22 is indicated in the bottom half of Figure 3. As shown in Figure 3, the source driver 23 is configured to drive the compensation radiation source 22 to provide the compensation radiation 25 at a high compensation power 62 during the dormant periods 42. By providing the compensation radiation 25 during the dormant periods 42, temperature uniformity of the gain medium 12 can be increased across the production periods 41 and the dormant periods 42. That is, the compensation radiation 25 increases temperature uniformity of the gain medium 12 over time. The compensation radiation 25 makes the temperature distribution within the gain medium 12 during the dormant periods 42 more similar to the temperature distribution within the gain medium 12 during the production periods 41. By providing the compensation radiation 25, the compensation radiation 25 can provide heat to the gain medium 12 during the dormant periods 42. By providing heat to the gain medium 12 during the dormant periods 42, variation in temperature of the gain medium 12 across the production periods 41 and the dormant periods 42 may be reduced.

In an embodiment, the source driver 23 is configured to drive the at least one radiation source 21, 22 such that the temperature of the gain medium 12 remains substantially uniform across the production periods 41 and the dormant periods 42. In an embodiment, the source driver 23 is configured to drive the at least one radiation source 21, 22 such that the temperature distribution in the gain medium 12 remains substantially temporally stable across the production periods 41 and the dormant periods 42. However, it is not essential for the temperature of the gain medium 12 to remain exactly uniform between the production periods 41 and the dormant periods 42. In an embodiment, the temperature of the gain medium 12 varies over time, for example between production periods 41 and dormant periods 42. In an embodiment the temperature of the gain medium 12 is more uniform over time than would be the case if the compensation radiation 25 was not provided.

The compensation radiation 25 is used to temporarily stabilize the temperature distribution in the gain medium 12, such that the thermal lens is more stable. There remains a thermal gradient in the gain medium 12. The temperature distribution is not expected to be perfectly uniform.

As is illustrated in Figure 3, the source driver 23 is configured to drive the compensation radiation source 22 to provide the compensation radiation 25 at a low compensation power 61 during the production periods 41. In an embodiment, the low compensation power 61 may correspond to substantially zero power. That is, the source driver 23 may be configured to switch off the compensation radiation source 22 during the production periods 41 and to switch on the compensation radiation source 22 during the dormant periods 42. In an alternative embodiment, the low compensation power 61 is non-zero. The lower compensation power 61 is lower than the high compensation power 62. The non-zero low compensation power 61 may, for example, stabilize the compensation radiation source 22 to minimize start-up effects or alike.

As shown in Figure 3, in an embodiment the source driver 23 is configured to drive the at least one radiation source 21, 22 to provide the production radiation 24 at a high production power 51 during the production periods 41. In an embodiment, the source driver 23 is configured to drive the at least one radiation source 21, 22 to provide the production radiation 24 at a low production power 52 during the dormant periods 42. The high production power 51 is greater than the low production power 52.

In an embodiment, the low production power 52 corresponds to substantially zero power. That is, the source driver 23 may be configured to switch off the production radiation source 21 during the dormant periods 42. The source driver 23 may be configured to switch on the production radiation source 21 during the production periods 41. However, it is not essential for the low production power to correspond to substantially zero power. In an alternative embodiment, the low production power 52 is non-zero. The source driver 23 may be configured to drive the production radiation source 21 to provide at least some production radiation 24 during both the production periods 41 and the dormant periods 42. The non-zero low production power 52 may, for example, stabilize the production radiation source 21 to minimize start-up effects or alike.

In an embodiment, the gain medium 12 is configured to absorb the production radiation 24 and the compensation radiation 25. The gain medium 12 may have a quantum defect that is different for the compensation radiation 25 than for the production radiation 24. When the gain medium 12 is pumped with radiation, some of that radiation may be lost in heat. In an embodiment the gain medium 12, the compensation wavelength, and the production wavelength are selected such that a higher proportion of the power from the compensation radiation 25 is lost in heat compared to the power from the production radiation 24.

As shown in Figure 3, in an embodiment the gain medium 12 can be pumped by the production radiation 24 during the production periods 41 when the laser radiation 13 (or radiation such as ultraviolet radiation 32 formed by converting the laser radiation 13) is needed. During the dormant periods 42, the production radiation source 21 can be switched off, or switched to the low production power 52. This lowers the thermal input by the production radiation 24 to the gain medium 12.

In an embodiment, the compensation radiation 25 is provided so as to replace the thermal input to the gain medium 12 that is removed, when the production radiation source 21 is switched to low production power 52. The compensation wavelength of the compensation radiation source 22 may be selected such that the absorption within the gain medium 12 is of comparable strength to that for the production radiation 24. For example, in an embodiment the gain medium 12 has an absorptance at the compensation wavelength that is at least half of its absorptance of the production wavelength. In an embodiment, the gain medium 12 has an absorptance at the compensation wavelength that is at least 80%, optionally at least 90%, and optionally at least 95% of the absorptance of the gain medium 12 at the production wavelength. By providing that the absorption within the gain medium 12 is similar in strength, the thermal compensation provided by the compensation radiation 25 may be more effective. In an embodiment, the gain medium 12 has an absorptance at the compensation wavelength that is greater than the absorptance of the gain medium 12 at the production wavelength. In an embodiment, the gain medium 12 has an absorptance at the compensation wavelength that is at least 110% of the absorptance of the gain medium 12 at the production wavelength. By providing a higher absorptance of the compensation wavelength within the gain medium 12, the thermal compensation provided by the compensation radiation 25 may be more effective, particularly when the gain medium 12 is formed as a thin disc.

However, it is not essential for the absorption within the gain medium 12 to be similar in strength for the compensation radiation 25 and the production radiation 24. In an alternative embodiment, the absorption of the compensation radiation 25 is far lower than for the production radiation 24. In an embodiment, a multipass pump geometry is used. Such multipass pump geometry may make it less important for the absorption within the gain medium 12 to be similar in strength. An example of a multipass pump geometry is a thin disc.

In an embodiment, the source driver 23 is configured to drive the at least one radiation source 21, 22 so as to deposit substantially the same amount of heat in the same volume of the gain medium 12 during the production periods 41 and during the dormant periods 42. In an embodiment substantially the same thermal gradient is generated, thereby helping to keep the thermal lensing properties of the gain medium 12 more stable.

In an embodiment, the production radiation source 21 is shut down during the dormant periods 42. By shutting down the production radiation source 21, or by reducing its power output, during the dormant periods 42, the lifetime of the production radiation source 21 may be increased. An embodiment of the invention is expected to increase the lifetime of the pump arrangement 20. An embodiment of the invention is expected to increase the lifetime of the solid-state laser 10. An embodiment of the invention is expected to reduce the cost of maintaining the pump arrangement 20. An embodiment of the invention is expected to reduce the cost of maintaining the solid-state laser 10.

In an embodiment, the production radiation 24 is closer in wavelength than the compensation radiation 25 to the fundamental lasing wavelength of the gain medium 12. In an embodiment, the gain medium 12 is configured to lase at a greater efficiency based on absorption of the production radiation 24 than based on absorption of the compensation radiation 25. The production radiation 24 may be provided during the production periods 41, when the laser radiation 13 is required. During the dormant periods 42, the greater heat loss associated with the compensation radiation 25 may be used to increase stability of the gain medium 12. An embodiment of the invention is expected to increase efficiency of energy usage.

Figure 4 schematically depicts an exemplary configuration of the cavity 11 of the solid-state laser 10 shown in Figure 2. Figure 4 schematically depicts a situation in which the gain medium 12 (crystal) is in a so-called cold state, i.e., the gain medium 12 is not (pre)heated by radiation. As shown in Figure 4, in an embodiment the cavity 11 comprises a plurality of optical elements 26. For example, the optical elements 26 may comprise reflectors such as cavity mirrors. Figure 4 also schematically depicts the form of a wavefront 27 (indicated by the lines) of any radiation (for example, radiation 13) that may propagate from the gain medium 12 after interaction with the gain medium 12. As shown in Figure 4, in the cold-state situation, there is substantially no distortion of the wavefront 27. Figure 4 shows a cold state of the solid-state laser 10, where there is substantially no thermal lensing effect.

Figure 5 schematically depicts the same cavity 11, as shown in Figure 4, during pumping of the gain medium 12 by the production radiation 24. As a result of providing the production radiation 24 to the gain medium 12, a portion of the production radiation 24 is lost within the gain medium 12 and hereby changing the temperature of the gain medium 12. The cavity as illustrated in Figure 5 is in a so-called thermalized state. The thermal change causes a thermal lensing effect. The thermal lensing is indicated in Figure 5 by the wavefront 27 being significantly curved. Though the cavity 11 may be designed to operate with a certain thermal lens effect, in general it is desirable for the thermal lensing effect to be reduced (or minimal), and for the thermal lensing effect to be more consistent (stable).

A similar thermal lensing effect can be generated by providing the compensation radiation 25 to the gain medium 12. That is, the compensation radiation 25 may cause substantially the same thermal lensing effect as during pumping with the production radiation 24. Thus, the situation as illustrated by Figure 5 may correspond to the situation during production periods 41. The same situation may correspond to the situation during dormant periods 42 with the difference that the compensation radiation 25 is provided to the gain medium 12 instead of the production radiation 24.

In general, thermal lenses are expected to vary slowly. By providing the compensation radiation 25, the thermal lens is maintained in a steadier state. By increasing the stability of the thermal lens between the production periods 41 and the dormant periods 42, the solid-state laser 10 may be switched more quickly to the on-state, i.e., the state in which the laser radiation 13 is provided during the production periods 41.

In an embodiment, the at least one radiation source 21, 22 comprises at least one production diode. For example, the production radiation source 21 may be an array of production diodes. The array comprises a plurality of diodes. For example, the array may comprise at least 5, at least 10, at least 20, at least 50, optionally at least 100, optionally at least 200, optionally at least 500, and optionally at least 1000 production diodes. The at least one production diode is configured to provide the production radiation 24. In an embodiment, the at least one radiation source 21, 22 comprises at least one compensation diode. The compensation diode is configured to provide the compensation radiation 25. For example, the compensation radiation source 22 may be an array of compensation diodes. The compensation array comprises a plurality of diodes. For example, the array may comprise at least 5, at least 10, at least 20, optionally at least 50, optionally at least 100, optionally at least 200, and optionally at least 500 compensation diodes.

In an embodiment, the array of production diodes and/or the array of compensation diodes comprises a plurality of individual pump diodes, one or more diode bars each comprising a row of emitting diodes, or one or more diode stacks each comprising a plurality of stacked diode bars. In an embodiment, the output of the at least one radiation source 21, 22 is guided to the gain medium 12 using an optical fiber.

In an embodiment, the at least one radiation source 21, 22 comprises at least one photonic-crystal surface-emitting laser (PCSEL). The PCSEL may have a single-spatial-mode emission and a higher efficiency in comparison with diodes. The production radiation source 21 may comprise a plurality of production PCSELs. The plurality of production PCSELs may be arranged in an array. The compensation radiation source 22 may comprise a plurality of compensation PCSELs. The plurality of compensation PCSELs may be arranged in an array.

By providing one or more diodes or PCSELs for pumping the gain medium 12, efficiency of the solid-state laser 10 may be increased compared to using a flashlamp to pump the gain medium 12. For example, in an embodiment the diode/PCSEL pumping facilitates continuous wave operation of the solid-state laser 10. In an embodiment the diode/PCSEL pumping facilitates quasi-continuous wave operation of the solid-state laser 10. An embodiment of the invention is expected to increase suitability of the solid-state laser 10 for use in, for example, a lithographic apparatus.

However, it is not essential for the at least one radiation source 21, 22 to consist of diodes or PCSELs. In an alternative embodiment the at least one radiation source comprises at least one solid state laser, at least one flashlamp and/or at least one arc lamp configured to pump the gain medium 12. In an alternative embodiment an LED pumped luminescent concentrator is provided.

In an embodiment, the at least one compensation radiation source 22 (e.g., a diode or PCSEL) has a longer lifetime than the at least one production radiation source 21 (e.g., a diode or PCSEL) under substantially the same operating conditions (for example, maintaining the same thermal condition of the gain medium 12). In an embodiment, the at least one compensation radiation source 22 is operated at a lower power compared to the at least one production radiation source 21. In an embodiment, the compensation radiation source 22 is configured to output compensation radiation at a lower cost per unit of power compared to the provision of the production radiation 24 by the production radiation source 21. By using the compensation radiation source 22 during the dormant periods 42, the power consumption during dormant periods 42 may be reduced. The lifetime of the production radiation source 21, which may be more expensive than the compensation radiation source 22, may be preserved.

However, it is not essential for the compensation radiation source 22 to have a longer lifetime than the production radiation source 21 under substantially the same operating conditions. In an alternative embodiment, the production radiation source 21 has substantially the same lifetime, or a longer lifetime, than the compensation radiation source 22 under substantially the same operating conditions.

In an embodiment, the compensation wavelength is shorter than the production wavelength. In an embodiment, the production wavelength is in the range of from about 600 nm to about 685 nm, and optionally from about 635 nm. For example, the production radiation source 21 may be configured to produce red light. In an embodiment, the compensation wavelength is less than 560 nm, for example in the range of from about 360 nm to about 560 nm, optionally at most about 540 nm, and optionally at most about 480 nm. In an embodiment, the production radiation source 21 is configured to provide red production radiation. In an embodiment, the compensation radiation source 22 is configured to provide blue or green compensation radiation.

In an embodiment the source driver 23 is configured to switch between the production radiation source 21 for operation of the solid-state laser 10 and the compensation radiation source 22 for preserving thermal stability. Such switching may be performed quickly. In an embodiment, the gain medium 12 has a higher quantum defect with the compensation radiation 25 than with the production radiation 24. The optical pump power in compensation radiation 25 may be less than the optical pump power in the production radiation 24 to achieve substantially the same thermal power being deposited into the gain medium 12. An embodiment of the invention is expected to reduce energy usage of the solid-state laser 10 for a given thermal stability of the gain medium 12.

The gain medium 12 may be provided with a heat unit that may act as a heat sink or as a heat source. External heat may be input into the gain medium 12 via the heat unit (acting as a heat source) or heat from the gain medium 12 may be extracted by the heat unit (acting as a heat sink). Providing heat to the gain medium 12 by use of the compensation radiation 25 may create substantially the same thermal gradient as created by the production radiation 24. Therefore, use of the compensation radiation 25 is more efficient than use of external heat input via the heat unit to stabilise the thermal gradient of the gain medium 12. The compensation radiation 25 may apply heat to the gain medium 12 on a shorter timescale compared to external heat input via the heat unit, as well as providing heat at the location of the optical path within the gain medium 12. Use of the compensation radiation 25 is expected to more accurately stabilise the thermal gradient of the gain medium 12.

In an exemplary embodiment, the solid-state laser 10 comprises a crystal of alexandrite (Cr³⁺:BeAl₂O₄) as the active gain medium 12. Alexandrite is a laser gain medium that can lase at wavelengths between 720 nm and 800 nm and has thermomechanical properties that are beneficial for optical applications. As mentioned in an earlier paragraph, 248 nm light, matching the wavelength of a KrF excimer laser wavelength, can be generated by a third harmonic generation process in a non-linear medium using 744 nm radiation as input radiation. As this wavelength (i.e., 744 nm) matches the lasing wavelength range of alexandrite, this material is well suitable as active gain medium 12 of the solid-sate laser 10. The same applies for generating 193 nm radiation, matching the 193 nm ArF excimer wavelength, by means of a fourth harmonic generation process using 772 nm radiation as input radiation. An embodiment of the invention may provide a solid-state laser suitable to replace excimer lasers, particularly in the context of a DUV radiation source.

Alexandrite is configured to absorb radiation at different wavelengths, in particular a wavelength in the red light range and a wavelength in the blue light range. Pumping an alexandrite crystal with radiation in the blue light range has a two to four times higher quantum defect compared to with radiation in the red light range. As a result, only one half to one quarter of the optical pump power in red is required for the same thermal power to be deposited into the alexandrite crystal with the blue light. An embodiment of the invention is expected to reduce energy usage.

An alternative embodiment of the gain medium 12 comprises an alternative chromium (Cr) doped material such as Cr:LiSAF and/or Cr:LiCAF. Though. It is not essential for the gain medium 12 to comprise a Cr doped material. In an alternative embodiment, the gain medium 12 comprises one or more of titanium doped sapphire or an ytterbium doped material such as Yb:YAG (Nd: Y₃Al₅0₁₂).

According to an embodiment, the source driver 23 is configured to drive the at least one radiation source 21, 22 to provide the compensation radiation 25 during the production periods 41 so as to increase temperature uniformity across an active region 14 of the gain medium 12. The active region 14 corresponds to the region of the gain medium 12 that is used for generating the laser radiation 13. By increasing temperature uniformity across the active region 14 of the gain medium 12, the thermal lensing effect of the gain medium 12 may be reduced or at least partially corrected. The thermal lensing effect may be partially correctable. By increasing temperature uniformity across the active region 14, the uncorrectable part of the thermal lensing effect may be reduced or substantially eliminated.

As illustrated in Figure 5, the wavefront 27 may be distorted as a result of thermal lensing. This thermal lensing may be correctable, for example using a deformable mirror and/or a phase plate. A first order thermal lens with a substantially spherical wavefront is at least partly correctable by spherical optics. The varying strength of a correctable thermal lens may be corrected, as the correction by cavity design or spherical optics is harder to make adjustable. An embodiment of the invention is expected to reduce or eliminate undesirable thermal lensing.

A combination of both the production radiation 24 and the compensation radiation 25 may be used to pump the gain medium 12. Especially, the cavity 11 shown in Figure 4 and Figure 5, may be provided with structured radiation. The radiation is structured in the sense that the shape or profile of the radiation on the gain medium 12 is controlled. The structured radiation may comprise both production radiation 24 and compensation radiation 25.

In an embodiment, the source driver 23 is configured to drive the at least one radiation source 21, 22 to provide the compensation radiation 25 during the production periods 41 such that the temperature of the gain medium 12 is substantially uniform across the active region 14. By providing that the temperature of the gain medium 12 is uniform across the active region 14, the refractive index of the gain medium 12 may be substantially uniform across the active region 14. The thermal lensing effect may be substantially eliminated.

However, it is not essential for the temperature of the gain medium 12 to be substantially uniform across the active region 14. In an alternative embodiment, a temperature gradient remains across the active region 14. This may lead to distortion of the wavefront 27, for example as shown in Figure 5. The remaining temperature gradient may be correctable within the cavity of the solid-state laser 10. For example, a curvature of at least one reflector of the cavity 11 may be selected so as to at least partially correct for the remaining temperature gradient. As another example, the cavity 11 may comprise at least one correcting lens element configured to at least partially correct for the remaining temperature gradient.

When only the production radiation 24 is used to pump the gain medium 12 during the production periods 41, the distortion of the wavefront 27 may be more complex. The distortion of the wavefront 27 is a result of the thermal lensing effect due to the temperature gradient across the gain medium 12. The thermal lensing may comprise higher powers that result in uncorrectable effects. The thermal lens comprises optical aberrations corresponding to irregular thermal lensing. A thermal lens associated with a substantially spherical wavefront is correctable. Any deviation from a thermal lens associated with a substantially spherical wavefront, for example aberrations that result in non-spherical wavefronts, is referred to here as uncorrectable.

By structuring both pump beams, i.e., the production radiation 24 and the compensation radiation 25, the heat load, and therefore thermal lens, can be shaped with the beams. This can help to counter the otherwise uncorrectable thermal lensing.

In an embodiment, the source driver 23 is configured to drive the at least one radiation source 21, 22 during the production periods 41 to provide the production radiation 24 and the compensation radiation 25 such that a gain is substantially uniform across the active region 14. Uniform gain may be maintained while structuring both pump beams. In contrast, if only the compensation radiation 25 were shaped, then the gain of the gain medium 12 would not be uniform. However, it is not essential for the gain to be substantially uniform across the active region 14. In an alternative embodiment, the gain is non-uniform. For example, in an embodiment only the compensation radiation 25 is shaped so as to counter the otherwise uncorrectable thermal lensing. This may reduce the thermal lensing compared to shaping neither the production radiation 24 nor the compensation radiation 25.

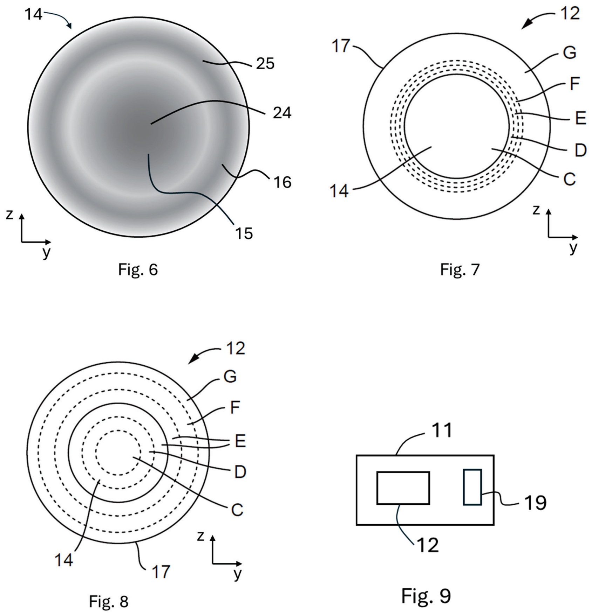

Figure 6 schematically depicts an alternative profile of structured pump radiation within the active region 14 of the gain medium 12. As shown in Figure 6, in an embodiment the source driver 23 is configured to drive the at least one radiation source 21, 22 during the production periods 41 to direct the production radiation 24 to an inner portion 15 of the active region 14 and the compensation radiation 25 to an outer portion 16 of the active region 14. The outer portion 16 is radially outward of the inner portion 15. In an embodiment, the outer portion 16 where the compensation radiation 24 is provided is directly adjacent to the inner portion 15 where the production radiation 24 is provided. That is, there is no area between the outer portion 16 and the inner portion 15 where there is no light. In an embodiment, the outer portion 16 where the compensation radiation 24 partially overlaps the inner portion 15 where the production radiation 24 is provided. Figure 6 shows the profile looking along the direction of propagation of the compensation radiation 25 and production radiation 24. By providing the compensation radiation 25 in the outer portion 16, the temperature of the outer portion 16 of the active region 14 may be increased, thereby increasing temperature uniformity across the active region 14.

Figures 7 and 8 schematically depict a temperature distribution across the gain medium 12. In Figure 7 and Figure 8, temperature is indicated using a scale of C (highest temperature) through to G (lowest temperature). Figure 7 schematically depicts a substantially uniform temperature across the active region 14. The peripheral region 17 is outside of the active region 14. It is less important to control the temperature of the gain medium 12 outside of the active region 14. The temperature in the peripheral region 17 may be lower than the temperature in the active region 14. As shown in Figure 7, there may be a relatively steep temperature gradient between the active region 14 and the peripheral region 17. Across the active region 14, the temperature is relatively stable, thereby reducing the thermal lensing of the gain medium 12.

Figure 8 shows the temperature distribution within a comparative gain medium 12. Figure 8 shows a less steep temperature gradient between the active region 14 and the peripheral region 17. In the example of Figure 8, the temperature is high in the central part of the active region 14. However, the temperature cools down towards the edge of the active region 14. By structuring the pump radiation as shown in Figure 6, for example, the temperature distribution across the gain medium 12 may become more similar to that shown in Figure 7 than that shown in Figure 8.

Other shaping of the production radiation 24 and the compensation radiation 25 is possible. In an embodiment, the structuring of the compensation radiation 25 and the production radiation 24 is selected so as to match the geometry of the gain medium 12.

As shown in Figure 6, for example, in an embodiment the gain medium 12 may have an elliptical (for example, circular) cross section. The active region 14 may have an elliptical (for example, circular) shape. The profile of the structured compensation radiation 25 and production radiation 24 may be elliptical (for example, circular).

In an embodiment the gain medium 12, which may have a disc shape, has a thickness of at least 0.2 mm, optionally at least 0.5 mm, optionally at least 1 mm and optionally at least 2 mm. By increasing the thickness of the gain medium 12, pump absorption may be increased. An embodiment of the invention is expected to reduce the requirements on the pump brightness. An embodiment of the invention is expected to reduce the cost of making the solid-state laser 10.

In an embodiment the gain medium 12 has a thickness of at most 10 mm, optionally at most 5 mm, optionally at most 2 mm and optionally at most 1 mm. By reducing the thickness of the gain medium 12, the lateral heat transport may be reduced, thereby reducing the temperature gradient across the active region 14 of the gain medium 12. An embodiment of the invention is expected to reduce the thermal lensing effect.

In an embodiment, the at least one radiation source 21, 22 is configured to provide the production radiation 24 substantially coaxially with the compensation radiation 25. By providing the coaxial arrangement, the structured pump radiation may match the symmetry of the gain medium 12. However, it is not essential for the production radiation 24 to be provided substantially coaxially with the compensation radiation 25. In an alternative embodiment, the production radiation 24 is provided to one side of the compensation radiation 25. The profile of the structured pump radiation may have the form of a dipole, for example.

Figure 9 schematically depicts a cavity 11 of the solid-state laser 10. As shown in Figure 9, the gain medium 12 is provided in the cavity 11. As shown in Figure 9, in an embodiment the cavity 11 comprises at least one adjustable element 19. In an embodiment, the adjustable element 19 is adjustable so as to adjust a configuration of the optical cavity 11. For example, the adjustable element 19 may comprise a reflector. The reflector may be movable, rotatable, or deformable, for example. The adjustable element 19 may be a adjustable polarizing element, such as a polarizing switch. In an embodiment, the optical cavity 11 has an adjustable configuration so as to increase temperature uniformity across the active region 14 of the gain medium 12. An embodiment of the invention is expected to match the dynamics of a change in thermal lens by changing properties of the laser cavity 11. Alternatively, the adjustable element 19 may comprise a lens, for example. The lens may be movable within the cavity 11.

However, it is not essential for the optical cavity 11 to be adjustable. In an alternative embodiment the optical cavity 11 has a substantially fixed configuration.

In an embodiment, the adjustable element 19 is configured to function as a blocker. That is, the adjustable element 19 may be a blocker (or shutter) configured to at least partially blocking a lasing action of the solid-state laser 10 during the dormant periods 42 so as to increase heat loss per unit power of the production radiation 24 during the dormant periods 42. This lowers the pump power requirements during the dormant periods 42 needed to maintain the same thermal profile. When the laser action is blocked, for example by introducing a loss into the cavity, part of the excited state population non-radiatively decays. Energy that would have escaped optically becomes a source of heat. This can increase the heat load on the gain medium 12. This may allow the output power of the at least one radiation source 21, 22 to be reduced while preserving the heat load on the gain medium 12. An embodiment of the invention is expected to reduce required output power of the at least one radiation source 21, 22. An embodiment of the invention is expected to increase lifetime of the pump arrangement 20. An embodiment of the invention is expected to improve energy efficiency.

In an embodiment, the source driver 23 is configured to drive the production radiation source 21 to provide the production radiation 24 during the dormant periods 42 as well as during the production periods 41. In an embodiment, the output power of the production radiation source 21 may be lower during the dormant periods 42 than during the production periods 41. By reducing the power output by the production radiation source 21, the lifetime of the production radiation source 21 may be prolonged. During the dormant periods 42, the production radiation 24 may continue to provide heat to the gain medium 12 so as to increase thermal stability of the gain medium 12.

In an embodiment, the source driver 23 is configured to drive the production radiation source 21 during the dormant periods 42 to output production radiation 24 below the lasing threshold. By providing the production radiation 24 below the lasing threshold, a greater proportion of the power output by the production radiation source 21 may be lost as heat in the gain medium 12. An embodiment of the invention is expected to increase efficiency of stabilising the gain medium 12 thermally. However, it is not essential for the production radiation 24 during the dormant periods 42 to be below the lasing threshold. In an alternative embodiment, the production radiation 24 is provided during the dormant periods 42 above the lasing threshold. In an embodiment, the lasing radiation 13 is blocked downstream of the solid-state laser 10 during the dormant period 42. For example, in an embodiment a fast-switching shutter is provided for blocking the laser radiation 13 during the dormant periods 42. In an embodiment the source driver 23 is configured to reduce the current provided to a diode of the production radiation source 21 so as to reduce the output power.

It will be appreciated by the person skilled in the art that, for example, in an embodiment an end mirror may be coated on a surface of the gain medium 12, to merge the functionality of the gain medium and a cavity mirror into one element.

In an embodiment, a method is provided for pumping the gain medium 12 of the solid-state laser 10. The gain medium 12 is pumped so as to produce laser radiation 13 during production periods 41 separated by dormant periods 42.

In an embodiment, the method for pumping comprises at least one radiation source 21, 22 providing production radiation 24 of a production wavelength and compensation radiation 25 of a compensation wavelength. The compensation wavelength is different from the production wavelength.

In an embodiment, the method for pumping comprises driving the at least one radiation source 21, 22 to provide the production radiation 24 at least during the production periods 41.

In an embodiment, the method comprises driving the at least one radiation source 21, 22 to provide the compensation radiation 25 so as to increase temperature uniformity of the gain medium 12. By increasing temperature uniformity, a thermal lensing effect may be reduced or eliminated. By increasing temperature uniformity, more consistent laser radiation 13 may be provided during the production periods 41. By increasing temperature uniformity, the laser efficiency may improve, and/or the beam quality may improve.

As explained in a previous paragraph, a dormant period 42 may be a moment in time when no laser radiation 13 (or a radiation such as DUV radiation 32 converted from the laser radiation 13) is required for the apparatus or system that uses this radiation. For example, if the DUV radiation 32 is used for exposing or inspecting a semiconductor substrate within a lithographic apparatus, or if laser radiation 13 is used in a metrology system, which may be part of a lithographic apparatus, the radiation 13, 32 may not be required during a dormant period 42 defined by an action or sequence step within the apparatus or system. Various dormant periods 42, which may vary in duration, may be a defined. An exemplary dormant period 42 is the time required for a substrate loading / unloading in the apparatus. Also, when using the DUV radiation 32 for exposing fields on a substrate, the time required for moving from one exposure field to another exposure field can define a dormant period 42. Also for inspection applications, the sequence of moving from one location (or position) of interest on a substrate for the inspection to another location may define a dormant period 42. The period between two dormant periods 42, may be defined as the production period 41. During the production period 41, DUV radiation 32 may be required (and used) to expose fields on a semiconductor substrate or laser radiation 13 may be required (and used) for performing measurements at a substrate.

Although specific reference may have been made above to the use of embodiments of the invention in the context of lithography, it will be appreciated that the invention, where the context allows, is not limited to lithography and may be used in other applications.

Aspects of the invention are described in the following numbered clauses.
1. An arrangement for producing laser radiation in a gain medium of a solid-state laser during production periods separated by dormant periods, the arrangement comprising:
   at least one radiation source configured to provide production radiation of a production wavelength to the gain medium and to provide compensation radiation of a compensation wavelength different from the production wavelength to the gain medium, the production radiation being provided to produce the laser radiation; and
   a source driver configured to drive the at least one radiation source to provide the production radiation at least during the production periods, wherein the source driver is further configured to drive the at least one radiation source to provide the compensation radiation so as to increase temperature uniformity of the gain medium.
2. The arrangement of clause 1, wherein the source driver is configured to drive the at least one radiation source to provide the compensation radiation during the dormant periods so as to increase temperature uniformity of the gain medium across the production periods and the dormant periods.
3. The arrangement of clause 2, wherein the source driver is configured to drive the at least one radiation source such that the temperature distribution in the gain medium remains substantially temporally stable across the production periods and the dormant periods.
4. The arrangement of any preceding clause, wherein the source driver is configured to drive the at least one radiation source to provide the compensation radiation at a higher power during the dormant periods than during the production periods.
5. The arrangement of any preceding clause, wherein the source driver is configured to drive the at least one radiation source to provide the production radiation at a higher power during the production periods than during the dormant periods.
6. The arrangement of any preceding clause, wherein the at least one radiation source comprises:
   at least one of a production diode and a production photonic-crystal surface-emitting laser (PCSEL) configured to provide the production radiation; and
   at least one of a compensation diode and a compensation photonic-crystal surface-emitting laser configured to provide the compensation radiation.
7. The arrangement of clause 6, wherein the at least one compensation diode or compensation PCSEL has a longer lifetime than the at least one production diode or production PCSEL under substantially the same operating conditions.
8. The arrangement of clause 6 or 7, wherein the at least one production diode or production PCSEL is configured to provide production radiation having a wavelength in a range of from about 600 nm to about 685 nm.
9. The arrangement of any of clauses 6-8, wherein the at least one compensation diode or compensation PCSEL is configured to provide compensation radiation having a wavelength in a range of from about 360 nm to about 560 nm.
10. The arrangement of any preceding clause, wherein the source driver is configured to drive the at least one radiation source to provide the compensation radiation during the production periods so as to increase temperature uniformity across an active region of the gain medium.
11. The arrangement of clause 10, wherein the source driver is configured to drive the at least one radiation source to provide the compensation radiation during the production periods such that the temperature distribution across the active region of the gain medium is substantially constant.
12. The arrangement of clause 10 or 11, wherein the source driver is configured to drive the at least one radiation source during the production periods to provide the production radiation and the compensation radiation such that a gain is substantially uniform across the active region.
13. The arrangement of any of clauses 10-12, wherein the source driver is configured to drive the at least one radiation source during the production periods to direct the production radiation to an inner portion of the active region and the compensation radiation to an outer portion of the active region radially outward of the inner portion.
14. The arrangement of any preceding clause, wherein the at least one radiation source is configured to provide the production radiation substantially coaxially with the compensation radiation.
15. A solid-state laser comprising:
   the arrangement of any preceding claim; and
   the gain medium, wherein the arrangement is configured to provide the production radiation and the compensation radiation to the gain medium.
16. The solid-state laser of clause 15, wherein the gain medium has an absorptance at the compensation wavelength that is at least half of its absorptance at the production wavelength.
17. The solid-state laser of clause 15 or 16, wherein the production radiation is closer in wavelength than the compensation radiation to the fundamental lasing wavelength of the gain medium.
18. The solid-state laser of any of clauses 15-17, wherein the gain medium comprises an alexandrite crystal.
19. The solid-state laser of any of clauses 15-18, wherein the gain medium has substantially a disc shape.
20. The solid-state laser of clause 19, wherein the disc shape has a thickness of at least 1 mm, optionally at least 2 mm.
21. The solid-state laser of any of clauses 15-20, comprising:
   a blocker configured to at least partially block a lasing action of the solid-state laser during the dormant periods so as to increase heat loss per unit power of the production radiation during the dormant periods.
22. The solid-state laser of any of clauses 15-21, comprising:
   an optical cavity surrounding the gain medium, wherein the optical cavity has an adjustable configuration.
23. A DUV radiation source comprising:
   the solid-state laser of any of clauses 15-22; and
   a wavelength converter configured to convert the laser radiation produced by the solid-state laser into DUV radiation having a wavelength of about 365 nm, 248 nm, or 193 nm.
24. A lithographic apparatus comprising the DUV radiation source of clause 23.
25. A method for producing laser radiation in a gain medium of a solid-state laser during production periods separated by dormant periods, the method comprising:
   driving at least one radiation source to provide a production radiation of a production wavelength to the gain medium at least during the production periods;
      producing laser radiation by the provision of the production radiation: and
   driving the at least one radiation source to provide a compensation radiation of a compensation wavelength different from the production wavelength so as to increase temperature uniformity of the gain medium.
26. The method of clause 25, wherein at least one production diode of the at least one radiation source provides the production radiation having a wavelength in a range of from about 600 nm to about 685 nm.
27. The method of clause 25 or 26, wherein at least one compensation diode of the at least one radiation source provides the compensation radiation having a wavelength in a range of from about 360 nm to about 560 nm.
28. The method of any of clauses 25-27, wherein during the production periods the at least one radiation source is driven to direct the production radiation to an inner portion of an active region of the gain medium and to direct the compensation radiation to an outer portion of the active region radially outward of the inner portion.
29. The method of any of clauses 25-28, wherein the at least one radiation source provides the production radiation substantially coaxially with the compensation radiation.
30. The method of any of clauses 25-29, wherein the gain medium comprises an alexandrite crystal.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. An arrangement for producing laser radiation in a gain medium of a solid-state laser during production periods separated by dormant periods, the arrangement comprising:
at least one radiation source configured to provide production radiation of a production wavelength to the gain medium and to provide compensation radiation of a compensation wavelength different from the production wavelength to the gain medium, the production radiation being provided to produce the laser radiation; and
a source driver configured to drive the at least one radiation source to provide the production radiation at least during the production periods, wherein the source driver is further configured to drive the at least one radiation source to provide the compensation radiation so as to increase temperature uniformity of the gain medium.

2. The arrangement of claim 1, wherein the source driver is configured to drive the at least one radiation source to provide the compensation radiation during the dormant periods so as to increase temperature uniformity of the gain medium across the production periods and the dormant periods.

3. The arrangement of claim 2, wherein the source driver is configured to drive the at least one radiation source such that the temperature distribution in the gain medium remains substantially temporally stable across the production periods and the dormant periods.

4. The arrangement of any preceding claim, wherein the source driver is configured to drive the at least one radiation source to provide the compensation radiation at a higher power during the dormant periods than during the production periods.

5. The arrangement of any preceding claim, wherein the source driver is configured to drive the at least one radiation source to provide the production radiation at a higher power during the production periods than during the dormant periods.

6. The arrangement of any preceding claim, wherein the at least one radiation source comprises:
at least one of a production diode and a production photonic-crystal surface-emitting laser (PCSEL) configured to provide the production radiation; and
at least one of a compensation diode and a compensation photonic-crystal surface-emitting laser configured to provide the compensation radiation.

7. The arrangement of any preceding claim, wherein the source driver is configured to drive the at least one radiation source to provide the compensation radiation during the production periods so as to increase temperature uniformity across an active region of the gain medium.

8. The arrangement of claim 7, wherein the source driver is configured to drive the at least one radiation source to provide the compensation radiation during the production periods such that the temperature distribution across the active region of the gain medium is substantially constant.

9. The arrangement of claim 7 or 8, wherein the source driver is configured to drive the at least one radiation source during the production periods to provide the production radiation and the compensation radiation such that a gain is substantially uniform across the active region.

10. The arrangement of any of claims 7 to 9, wherein the source driver is configured to drive the at least one radiation source during the production periods to direct the production radiation to an inner portion of the active region and the compensation radiation to an outer portion of the active region radially outward of the inner portion.

11. The arrangement of any preceding claim, wherein the at least one radiation source is configured to provide the production radiation substantially coaxially with the compensation radiation.

12. A solid-state laser comprising:
the arrangement of any preceding claim; and
the gain medium, wherein the arrangement is configured to provide the production radiation and the compensation radiation to the gain medium.

13. The solid-state laser of claim 12, wherein the production radiation is closer in wavelength than the compensation radiation to the fundamental lasing wavelength of the gain medium.

14. A method for producing laser radiation in a gain medium of a solid-state laser during production periods separated by dormant periods, the method comprising:
driving at least one radiation source to provide a production radiation of a production wavelength to the gain medium at least during the production periods;
producing laser radiation by the provision of the production radiation: and
driving the at least one radiation source to provide a compensation radiation of a compensation wavelength different from the production wavelength so as to increase temperature uniformity of the gain medium.

15. The method of claim 14, wherein the at least one radiation source provides the production radiation substantially coaxially with the compensation radiation.
